(19) Europäisches Patentamt
European Patent Office
Office européen des brevets

(11) **EP 3 727 725 B1**

(12) **FASCICULE DE BREVET EUROPEEN**

(45) Date de publication et mention de la délivrance du brevet:
**23.03.2022 Bulletin 2022/12**

(21) Numéro de dépôt: **18826034.3**

(22) Date de dépôt: **20.12.2018**

(51) Classification Internationale des Brevets (IPC):
**B22D 27/04** *(2006.01)*    **C30B 11/00** *(2006.01)*
**C30B 29/06** *(2006.01)*    **C30B 29/08** *(2006.01)*

(52) Classification Coopérative des Brevets (CPC):
**B22D 27/04; C30B 11/002; C30B 11/003; C30B 29/06; C30B 29/08**

(86) Numéro de dépôt international:
**PCT/EP2018/086172**

(87) Numéro de publication internationale:
**WO 2019/122111 (27.06.2019 Gazette 2019/26)**

(54) **CREUSET POUR SOLIDIFICATION DIRIGEE**

**TIEGEL FÜR DIREKTIERTE SOLIDIFIKATION**

**CRUCIBLE FOR DIRECTED SOLIDIFACTION**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2017 FR 1762769**

(43) Date de publication de la demande:
**28.10.2020 Bulletin 2020/44**

(73) Titulaire: **Commissariat à l'Energie Atomique et aux Energies Alternatives**
**75015 Paris (FR)**

(72) Inventeurs:
• **PIHAN, Etienne**
**38054 Grenoble Cedex 09 (FR)**
• **CHAVRIER, Denis**
**38054 Grenoble Cedex 09 (FR)**
• **PLASSAT, Nelly**
**38054 Grenoble Cedex 09 (FR)**
• **PONTHENIER, Damien**
**38054 Grenoble Cedex 09 (FR)**

(74) Mandataire: **Nony**
**11 rue Saint-Georges**
**75009 Paris (FR)**

(56) Documents cités:
EP-A1- 2 839 901      CN-A- 102 179 506
US-A1- 2012 297 580   US-A1- 2016 339 515

EP 3 727 725 B1

## Description

La présente invention concerne un creuset pour la solidification dirigée d'un lingot d'un semi-conducteur tel que le silicium et le germanium.

La solidification dirigée d'un lingot de silicium adapté aux applications photovoltaïques est un procédé de fabrication qui met en œuvre des phénomènes physiques, mécaniques et thermiques complexes, et couplés les uns aux autres. Elle peut être opérée par reprise sur germes d'un bain de silicium en fusion contenu dans un creuset de silice dont la paroi interne est revêtue d'un revêtement anti-adhérent en nitrure de silicium. Le creuset est disposé dans une enceinte comportant des régions formées de graphite et forme avec le revêtement anti-adhérent et l'enceinte des sources d'impuretés, notamment de métaux, d'oxygène, d'azote et de carbone respectivement, qui diffusent dans le bain de silicium en fusion et qui dégradent les propriétés optiques et électriques du lingot. L'azote est par exemple connu pour réduire la transparence dans l'infrarouge du silicium ainsi que la qualité des plaquettes obtenues après découpe du lingot au moyen d'une scie diamantée. En outre, les variations locales de température au sein du bain de silicium en fusion induisent des courants de convection naturelle qui favorisent la ségrégation des impuretés au niveau de l'interface entre le silicium solidifié et le bain de silicium en fusion.

Par ailleurs, des contraintes thermomécaniques apparaissent au cours de la solidification dirigée dans le lingot de silicium en formation, et résultent de gradients de température se développant d'abord dans les germes au cours de la fusion de la charge de départ pour former le bain, puis entre les régions centrale et périphérique du lingot en cours de solidification. De telles contraintes thermomécaniques sont à l'origine de la multiplication d'amas de dislocations, formant notamment des sous joints dans le lingot, qui dégradent les propriétés électriques. De plus, l'intensité des contraintes thermomécaniques augmente à mesure que la hauteur de matériau solidifié augmente. En outre, pour une hauteur de lingot fixée, l'intensité des contraintes thermomécaniques peut augmenter avec la largeur du lingot. La croissance de lingots de grande hauteur et de grande largeur, avantageuse économiquement, s'avère donc difficile en pratique.

La présente invention vise à pallier au moins l'un des inconvénients précités, et propose un creuset pour la solidification dirigée d'un lingot en un matériau de lingot choisi parmi le silicium, le germanium et leurs mélanges, le creuset comportant :

- un moule comportant une paroi de fond de moule et une paroi latérale de moule s'étendant depuis la paroi de fond de moule le long d'une direction axiale, la paroi de fond de moule et la paroi latérale de moule définissant ensemble une cavité pour contenir le matériau de lingot en fusion, et

- un manchon de maintien s'étendant selon la direction axiale et comportant un matériau de manchon dont la conductivité thermique est anisotrope et présente des composantes radiale $\lambda_r^{mc}$ et axiale $\lambda_x^{mc}$ telles que :

  o

$$\frac{\lambda_r^{mc}}{\lambda_x^{mc}} > 1,0$$

  o $\dfrac{\lambda_r^{mc}}{\lambda^{moule}} > 1,0$, $\lambda^{moule}$ étant la conductivité thermique du matériau de moule (10),

  o $\dfrac{\lambda_r^{mc}}{\lambda^{gr}} < 1,0$ et $\dfrac{\lambda_x^{mc}}{\lambda^{gr}} < 1,0$, $\lambda^{gr}$ étant la conductivité thermique du graphite, le manchon de maintien ceinturant la paroi latérale de moule autour de la direction axiale, les conductivités thermiques étant mesurées par application de la norme ASTM-1461 ou ASTM C-177.

Lorsque le creuset est disposé dans un four au sein duquel il est au contact d'un bloc échangeur thermique par sa partie inférieure, au cours de la solidification dirigée du lingot, le matériau de manchon, plus isolant axialement que radialement, limite la propagation axiale dans le manchon de maintien des flux de chaleurs en provenance du bloc échangeur thermique. La régulation des flux de chaleur appliqués radialement au lingot et au bain de silicium en fusion est facilitée, comme cela apparaîtra plus clairement par la suite. On peut ainsi plus aisément limiter le développement de contraintes thermomécaniques et des défauts cristallins associés dans le lingot. Il est alors possible de fabriquer un lingot de plus grande hauteur et présentant une densité de défauts cristallins sensiblement identique qu'au moyen d'un creuset de l'art antérieur présentant une cavité de dimensions identiques ou un lingot de mêmes dimensions présentant une plus faible densité de défauts cristallins.

De préférence, le creuset est adapté à la solidification dirigée d'un lingot de silicium.

La direction « axiale » passe par les barycentres respectifs des sections transverses, c'est-à-dire parallèles à des plans radiaux, du moule. De préférence, la direction axiale est la direction verticale, parallèle à la direction de la gravité terrestre.

Une direction « radiale » est contenue dans un plan transverse à la direction axiale et intersecte la direction « axiale ».

Un plan « radial » est défini par deux directions radiales différentes. Un plan axial comporte une direction parallèle à la direction axiale.

La « hauteur » d'un élément est mesurée selon la direction axiale. La largeur d'un élément est la plus grande dimension mesurée dans un plan radial. Par exemple, la plus grande dimension d'un lingot ou d'une cavité ayant une section transverse en forme de rectangle, est la diagonale du rectangle.

La « conductivité thermique » d'un matériau est déterminée dans une plage de températures comprise entre $T_f$ - 500°C et $T_f$ + 200°C, $T_f$ étant la température de fusion du matériau de lingot. La conductivité thermique d'un matériau est mesurée par application de la norme ASTM-1461 ou ASTM C-177. Elle peut aussi être obtenue de publications du domaine technique de l'invention, telles que « *Handbooks of materials properties - thermal conductivity* ». En particulier, dans une variante où le matériau de lingot comporte plus de 99,9% de silicium, la température de fusion $T_f$ du matériau de lingot est égale à 1414°C. Selon une autre variante où le matériau de lingot comporte plus de 99,9% de germanium, la température de fusion $T_f$ du matériau de lingot est égale à 938°C.

Une première pièce qui « entoure », voire qui « ceinture », une deuxième pièce autour de la direction axiale est disposée radialement à l'extérieur par rapport à la deuxième pièce. Une deuxième pièce disposée « radialement à l'intérieur » d'une première pièce est telle que la distance, mesurée selon une direction radiale, qui la sépare de la direction axiale, est inférieure à la distance, mesurée selon la direction radiale, entre la direction axiale et la première pièce disposée « radialement à l'extérieur ».

De préférence, le matériau de manchon présente un module de Young adapté au maintien de la forme du moule au cours de la solidification dirigée du lingot. L'homme du métier sait mettre en œuvre des méthodes de mesure d'un module de Young. Par exemple, lorsque le matériau de manchon comporte du graphite, le module de Young peut être mesuré selon les normes ASTM C747 et ASTM C769.

Par « maintien de la forme du moule au cours de la solidification dirigée », on considère que la variation, au cours de la solidification dirigée, entre la largeur du moule et la largeur initiale du moule avant solidification dirigée, mesurée à 30°C, n'excède pas 3 % de la largeur initiale du moule. Par exemple, dans une variante préférée où le moule est formé de silice, pour mettre en œuvre la solidification dirigée d'un lingot de silicium, le moule est chauffé à une température supérieure à la température de transition vitreuse de la silice. Au-delà de la température de transition vitreuse, une diminution temporaire de la rigidité du moule est observée. Ainsi, le manchon de maintien évite que le moule en silice ne se déforme trop sous l'effet de son ramollissement et de la pression induite par le matériau contenu dans la cavité. Le moule présente ainsi au cours de la solidification dirigée une forme sensiblement identique à celle qu'il présente à température ambiante.

Le manchon de maintien est creux. De préférence, le manchon de maintien entoure la paroi latérale de moule sur toute la face radialement extérieure de la paroi latérale de moule. De préférence, le creuset est configuré pour que le manchon de maintien entoure la paroi latérale de moule sur toute la hauteur du bain de matériau de lingot en fusion et/ou du lingot en cours de solidification, lorsque le creuset contient un tel bain et/ou un tel lingot. En particulier, le manchon de maintien peut avoir une forme complémentaire de la paroi latérale de moule. Il comporte au moins une ouverture débouchant à une extrémité du manchon et de préférence une autre ouverture à l'extrémité opposée selon la direction axiale.

De préférence, le manchon de maintien est un tube, de préférence cylindrique, par exemple de révolution. De préférence, le manchon de maintien présente une section transverse présentant des contours interne et externe rectangulaires, notamment carrés.

Le manchon de maintien comporte de préférence une paroi de manchon qui s'étend selon une direction parallèle à la direction axiale et ceinture la paroi latérale de moule autour de la direction axiale. De préférence, la paroi de manchon est au contact de la paroi latérale de moule.

De préférence, la paroi de manchon est intégralement formée par le matériau de manchon.

De préférence, la paroi de manchon est d'épaisseur constante, par exemple comprise entre 5 mm et 50 mm. L' « épaisseur » d'une paroi correspond à la plus grande distance entre deux grandes faces opposées de la paroi, mesurée selon une direction radiale. La paroi de manchon peut présenter plusieurs faces externes et internes.

Le manchon de maintien peut être monolithique. En variante, le manchon de maintien peut comporter une pluralité de portions de manchon amovibles liées les unes aux autres, par exemple au moyen de cornières sur lesquelles deux portions de manchons adjacentes sont vissées.

La paroi de manchon de maintien peut présenter une hauteur comprise entre 100 mm et 1000 mm, une largeur comprise entre 100 mm et 2200 mm. L'épaisseur de la paroi de manchon peut être comprise entre 5 mm et 50 mm.

Le matériau de manchon présente une conductivité thermique anisotrope dont les composantes radiale $\lambda_r^{mc}$ et axiale $\lambda_x^{mc}$ sont telles que le rapport $\dfrac{\lambda_r^{mc}}{\lambda_x^{mc}}$ est supérieur à 1,0. De préférence, le rapport $\dfrac{\lambda_r^{mc}}{\lambda_x^{mc}}$ est supérieur à 1,5, de préférence supérieur à 5,0, de préférence supérieur à 10,0, voire même supérieur à 20,0. Le manchon de maintien transmet ainsi plus aisément les flux de chaleur radiaux que les flux de chaleurs axiaux, ce qui facilite le maintien d'une forme prédéterminée du front de solidification au cours de la solidification dirigée du lingot.

De préférence, le rapport $\dfrac{\lambda_r^{mc}}{\lambda^{moule}}$ de la com-

posante radiale $\lambda_r^{mc}$ de la conductivité thermique du matériau de manchon sur la conductivité thermique du matériau de moule $\lambda^{moule}$ est inférieur à 0,8, de préférence inférieur à 0,5, voire inférieur à 0,2.

De préférence, le rapport $\dfrac{\lambda_r^{mc}}{\lambda^{gr}}$ de la composante radiale $\lambda_r^{mc}$ de la conductivité thermique du matériau de manchon sur la conductivité thermique du graphite $\lambda^{gr}$ est inférieur à 1,0.

De préférence, la composante radiale $\lambda_r^{mc}$ de la conductivité thermique du matériau de manchon est supérieure à 10 W.m⁻¹.K⁻¹.

De préférence, la composante axiale $\lambda_x^{mc}$ de la conductivité thermique du matériau de manchon est inférieure à 10 W.m⁻¹.K⁻¹, de préférence inférieure à 1 W.m⁻¹.K⁻¹.

De préférence, le matériau de manchon est un matériau composite comportant pour plus de 95,0% de sa masse, une région conductrice de manchon (45) formée de graphite, et une région d'isolation de manchon (40) formée d'un matériau choisi parmi un feutre de carbone, de préférence présentant une densité inférieure à 0,3g/cm³, et une laine minérale, par exemple une laine d'alumine, et leurs mélanges. En variante, le matériau de manchon peut être homogène.

Le feutre de carbone est également dénommé fibre de carbone ou fibre graphite dans le domaine technique de l'invention. Il peut être rigide, souple ou semirigide.

Le matériau de la région d'isolation de manchon peut présenter une conductivité thermique anisotrope dont la composante radiale est supérieure à la composante axiale.

De préférence, la région conductrice de manchon et la région d'isolation de manchon s'étendent chacune de part en part de l'épaisseur de la paroi de manchon.

De préférence, la région conductrice de manchon et la région d'isolation de manchon sont définies par des portions respectives du manchon de maintien, chaque portion étant intégralement contenue entre deux plans radiaux.

La région conductrice de manchon et la région d'isolation de manchon peuvent définir des portions de manchon amovibles telles que décrites précédemment.

De préférence, la région conductrice de manchon et la région d'isolation de manchon sont superposées l'une à l'autre selon la direction axiale et sont au contact l'une de l'autre.

De préférence la région conductrice de manchon et la région d'isolation de manchon sont fixées l'une sur l'autre. En variante, le manchon de maintien peut comporter une ossature, formée par exemple de graphite ou d'un composite de carbone rigide, définissant des ouvertures dans lesquelles la région conductrice de manchon et la région d'isolation de manchon sont logées. La région conductrice de manchon et la région d'isolation de manchon peuvent être fixées, par exemple par collage, par rivetage ou par vissage, à l'ossature.

L'épaisseur de la région conductrice de manchon et l'épaisseur de la région d'isolation de manchon peuvent être identiques.

De préférence, la région conductrice de manchon et la région d'isolation de manchon présentent des sections transverses identiques, selon un plan de coupe transversal à la direction axiale.

Selon une variante préférée, le creuset comporte une pluralité de régions conductrices de manchon et une pluralité de régions d'isolation de manchon, les régions conductrices de manchon et les régions d'isolation de manchon étant disposées en alternance selon la direction axiale. De préférence, une des régions conductrices de manchon et une des régions d'isolation de manchon consécutivement disposées selon la direction axiale définissent ensemble un motif ($M_m$) qui est répété périodiquement le long de la direction axiale.

Le motif peut notamment être formé d'une région conductrice de manchon tubulaire et d'une région d'isolation de manchon tubulaire présentant des sections transverses identiques, par exemple de contours intérieur et extérieur rectangulaires, notamment carrés.

De préférence, le rapport de la hauteur d'un motif sur l'épaisseur de la paroi de manchon est compris entre 0,1 et 5,0, de préférence compris entre 0,3 et 3,0. En particulier la hauteur d'un motif peut être comprise entre 5 mm et 100 mm, de préférence entre 15 mm et 50 mm

Le rapport de la hauteur de la région d'isolation de manchon du motif sur la hauteur du motif peut être compris entre 0,05 et 0,7. En particulier, la hauteur de la région d'isolation de manchon du motif peut être comprise entre 2 mm et 25 mm.

En ce qui concerne le moule, il est constitué, de préférence pour plus de 90%, de préférence pour plus de 99%, voire pour 100% de sa masse par un matériau de moule.

La conductivité thermique du matériau de moule est inférieure à la composante radiale de la conductivité thermique du matériau de manchon.

Un matériau de moule préféré est la silice.

Le moule définit une cavité pour contenir le matériau de lingot en fusion. Le volume de la cavité peut être supérieur à 10 litres, de préférence supérieur à 100 litres, de préférence supérieur à 250 litres, voire supérieur à 500 litres.

La cavité peut présenter une section radiale de contour circulaire ou de préférence rectangulaire, notamment carré.

Les faces de la paroi latérale de moule et de la paroi de fond de moule définissant la cavité peuvent être recouvertes d'un revêtement anti-adhérent, notamment en nitrure de silicium.

La paroi latérale de moule peut définir un cylindre de révolution. Selon une variante préférée, la paroi latérale de moule peut comporter une pluralité de portions de moule, de préférence présentant chacune une forme de plaque d'épaisseur constante, définissant un tube creux de section rectangulaire ou carrée. De préférence, la distance entre deux faces opposées de la paroi latérale de moule, mesurée selon une direction normale aux parois est comprise entre 100 mm et 2000 mm.

La hauteur de la paroi latérale de moule peut être supérieure à la hauteur de la paroi de manchon. En particulier, l'altitude de l'extrémité supérieure de la paroi latérale de moule peut être supérieure à l'altitude de l'extrémité supérieure de la paroi de manchon. L' « altitude » est mesurée selon la direction axiale, dans le sens opposé à celui de la gravité terrestre, par rapport à une position de référence prédéterminée, par exemple la face de la paroi de fond de moule opposée à la face en regard de la cavité.

Le moule est de préférence au contact du manchon de maintien. De préférence, la face radialement intérieure de la paroi de manchon est en contact de la face radialement extérieure de la paroi latérale de moule.

Le moule est adapté à la fabrication de lingot par solidification dirigée. De préférence, le rapport de la hauteur de la cavité sur la largeur de la cavité est inférieur à 2,0, de préférence inférieur à 0,5.

De préférence, le creuset comporte une sole disposée au contact de la paroi de fond de moule et du manchon de maintien, la sole étant formée d'un matériau de sole présentant une conductivité thermique $\lambda^{so}$ supérieure à la composante axiale $\lambda_x^{mc}$ de la conductivité thermique du matériau de manchon.

De préférence, le matériau de sole présente une conductivité thermique $\lambda^{so}$ supérieure à 10 W.m⁻¹.K⁻¹, de préférence supérieure à 30 W.m⁻¹.K⁻¹.

De préférence, le matériau de sole est le graphite.

La sole peut s'étendre dans un plan radial. De préférence, la paroi de fond de moule est en contact avec la sole sur l'intégralité de sa face opposée à celle en regard de la cavité.

De préférence, la surface de contact entre le manchon de maintien et la sole est définie entièrement par la région d'isolation de manchon. La transmission d'un flux de chaleur selon la direction axiale entre la sole et la paroi de manchon est ainsi limitée.

Par ailleurs, l'invention concerne un four pour la solidification dirigée d'un lingot en un matériau de lingot choisi parmi le silicium, le germanium et leurs mélanges, le four étant décrit dans la revendication 11 associée.

De préférence, le creuset est au contact du bloc échangeur thermique. De préférence, la sole est au contact du bloc échangeur thermique.

La conductivité thermique $\lambda^{et}$ du matériau d'écran est de préférence inférieure à 10 W.m⁻¹.K⁻¹, de préférence inférieure à 3 W.m⁻¹.K⁻¹, de préférence inférieure à 1 W.m⁻¹.K⁻¹.

L'écran de régulation thermique isole radialement une portion du creuset et le cas échéant du lingot qui y est contenu. Au cours de la solidification du lingot, l'écran de régulation thermique peut être déplacé relativement à l'ensemble de solidification, et notamment relativement au creuset, ce qui détermine la forme et la position du front de solidification. La position de l'écran de régulation relativement au creuset selon la direction axiale influe sur les conditions thermiques qui sont appliquées différemment au lingot solidifié et au matériau de lingot en fusion. L'intensité des gradients thermiques, notamment radiaux, dans le lingot peut ainsi être réduite par un choix prédéterminé du déplacement de l'écran de régulation thermique au cours de la solidification du lingot, que l'homme du métier peut déterminer, par exemple par simulation numérique ou à partir de de la détermination de la position et la forme de l'interface solide/liquide, ou expérimentalement par mesure physique, notamment au moyen de thermocouples. Par exemple, la détermination de la position et de la forme de l'interface solide/liquide est mesurée par « palpage », c'est-à-dire par mise en contact avec le lingot en formation d'une canne en quartz immergée dans le bain de matériau de lingot en fusion. Le palpage de l'interface solide/liquide peut être réalisé en différentes positions radiales, par exemple au centre le long de l'axe du moule et/ou le long de la paroi du moule, et à différents instants de la solidification du lingot. Ainsi, la germination et la croissance de grains parasites sur la périphérie du lingot peut être contrôlée. En outre, un déplacement adapté de l'écran de régulation peut assurer que l'interface entre le matériau de lingot solidifié et le matériau de lingot en fusion conserve une forme constante, de préférence convexe tout au long de la solidification dirigée du lingot. Par la suite, par souci de concision, l'interface entre le matériau de lingot solide et le bain de matériau de lingot en fusion pourra être dénommée interface « solide/liquide ». La précipitation des impuretés diffusant dans le bain de silicium peut ainsi être maîtrisée. Au contraire, avec les dispositifs de l'art antérieur, la forme de l'interface solide/liquide et la précipitation des impuretés sont des phénomènes subis : l'interface est généralement concave en début de formation du lingot, puis devient convexe, le rayon de courbure de l'interface convexe augmentant avec la hauteur de lingot formé. Ainsi, selon l'invention, on améliore la qualité du lingot obtenu, en réduisant l'accumulation d'impuretés, par exemple des précipités à l'interface solide/liquide.

De préférence, l'ensemble de solidification est immobile par rapport au sol sur lequel le four est disposé, et l'écran de régulation thermique est mobile par rapport au sol. On évite ainsi la mise en œuvre de moyens de levage chers et complexes pour déplacer le creuset comme dans l'art antérieur, notamment lorsque le four est destiné à la production d'un lingot présentant un rapport de la hauteur sur la largeur inférieur à 1,0 et un volume supérieur à 100 litres.

De préférence, l'écran de régulation thermique ceinture intégralement le creuset autour de la direction axiale. On peut ainsi imposer des flux de chaleur radiaux spécifiques, par exemple identiques quelle que soit la direction radiale, sur toutes les faces du lingot. De préférence, la distance radiale entre les faces en regard de l'écran de régulation thermique et du creuset est comprise entre 5 mm et 25 mm. Notamment, au-delà d'une distance de 25 mm à 40 mm, la région d'isolation d'écran est trop éloignée de la paroi latérale de moule pour former une barrière thermique efficace. De préférence la distance radiale entre l'axe d'extension de l'écran de régulation thermique et l'axe du moule est inférieure à 15 mm. De préférence, le moule et l'écran de régulation thermique sont coaxiaux.

De préférence, l'écran de régulation thermique présente une forme générale tubulaire et creuse, s'étendant selon la direction axiale entre deux plans radiaux distincts. Par exemple, l'écran de régulation thermique présente une section transverse de contours intérieur et extérieur rectangulaires, notamment carrés. De préférence, l'écran de régulation thermique comporte une paroi d'écran s'étendant selon la direction axiale, de préférence présentant une épaisseur constante. Par exemple, l'épaisseur de la paroi d'écran est comprise entre 5 mm et 80 mm, de préférence compris entre 15 mm et 40 mm.

De préférence, la conductivité thermique du matériau d'écran est inférieure à 10 $W.m^{-1}.K^{-1}$, de préférence inférieure à 1 $W.m^{-1}.K^{-1}$. Le matériau d'écran peut être choisi parmi un feutre de carbone, une laine minérale, par exemple une laine d'alumine et leurs mélanges.

Le matériau d'écran et le matériau de manchon peuvent être identiques ou différents.

Selon une première variante, l'écran de régulation thermique peut présenter une région d'isolation d'écran formée du matériau d'écran et une région conductrice d'écran formée de graphite. Au cours de la solidification du lingot, la région conductrice d'écran composée de graphite peut être disposée en regard du matériau de lingot en fusion et la région d'isolation d'écran peut être disposée en regard du lingot en formation, ce qui permet d'apporter radialement de l'énergie thermique au matériau de lingot en fusion tout en isolant thermiquement le lingot en formation. De préférence, la région d'isolation d'écran et la région conductrice d'écran sont séparées par un plan s'étendant radialement. De préférence, la région d'isolation d'écran est disposée sous la région conductrice d'écran selon la direction verticale. Autrement dit, elle est située à une altitude inférieure de la région conductrice d'écran.

De préférence, la région conductrice d'écran et la région d'isolation d'écran s'étendent chacune selon la direction axiale. Selon une deuxième variante, l'écran de régulation thermique est constitué par la région d'isolation d'écran formée du matériau d'écran. La hauteur de région d'isolation d'écran peut être supérieure à 50 %, de préférence supérieure à 80 %, voire supérieure à la hauteur de la paroi latérale de moule. Ainsi, au cours de la solidification dirigée d'un lingot, lors du déplacement de l'écran de régulation thermique par rapport au creuset, la portion du lingot directement ou indirectement, par exemple par l'intermédiaire des germes, au contact de la paroi de fond de moule est ceinturée par la région d'isolation d'écran. De cette façon, ladite portion du lingot est isolée des flux de chaleurs radiaux pour chauffer le bain de matériau de lingot en fusion, ce qui permet de réduire l'intensité des gradients de température radiaux à l'intérieur de la portion du lingot.

Par ailleurs, le four comporte de préférence un module de pilotage configuré pour translater l'écran de régulation thermique par rapport à l'ensemble de solidification, notamment de sorte à maintenir une interface convexe entre le lingot solidifié et le bain de matériau de lingot en fusion au cours de la solidification dirigée du lingot. Comme indiqué ci-dessus, l'homme du métier sait modéliser ou mesurer, par exemple par palpage, l'évolution de l'interface solide/liquide au cours de la solidification dirigée dans le four. Il est donc à même de déterminer, en fonction des paramètres de chauffage du four et de refroidissement du lingot, les conditions de déplacement de l'écran thermique, telles que par exemple la vitesse de déplacement et la durée de phases statiques de l'écran de régulation thermique, de manière à imposer une forme spécifique de l'interface solide/liquide.

De préférence, le module de pilotage est configuré pour translater l'écran de régulation thermique par rapport à l'ensemble de solidification de sorte que la hauteur de l'interface solide/liquide convexe et/ou le rapport entre la hauteur de l'interface solide/liquide et la largeur de l'interface solide/liquide soient constants sur plus de 80%, de préférence sur plus de 90%, de préférence sur plus de 95%, voire sur 100% de la hauteur du lingot à solidifier.

Une interface solide/liquide « convexe » est telle qu'un point de l'interface solide/liquide dans la région centrale du lingot en solidification est situé à une altitude plus élevée qu'un point de l'interface au contact de la paroi latérale de moule. De préférence, la hauteur de l'interface solide/liquide est inférieure à 3 cm et préférentiellement inférieure à 1 cm. La hauteur de l'interface solide/liquide correspond à la différence d'altitude entre le point de l'interface solide/liquide d'altitude la plus élevée et le point de l'interface liquide/solide au contact de la paroi latérale de moule.

Le bloc échangeur thermique est configuré pour extraire, par exemple par conduction, la chaleur contenue dans le creuset au cours de la solidification du lingot, et notamment assurer la solidification du matériau de lingot au contact de germes disposés sur la paroi de fond de moule. Par exemple, le bloc échangeur thermique peut consister en un bloc de graphite présentant une masse supérieure à 10 kg. Selon un autre exemple, il est constitué par une boîte à eau en cuivre dans lequel circule un liquide caloporteur, par exemple de l'eau, à une température comprise entre 15°C et 40°C.

Le four peut comporter une enceinte, par exemple formée de fibre de carbone, définissant un logement dans lequel l'écran de régulation thermique et l'ensemble de solidification sont disposés. L'enceinte peut comporter une base sur laquelle repose l'ensemble de solidification et un couvercle amovible pour accéder au logement. De préférence, l'enceinte se divise en deux parties selon la direction axiale à une position axiale plus basse que le plan de charge du four représenté par le fond du creuset. L'enceinte peut comporter une ou plusieurs parois d'enceinte sur lesquelles est monté au moins un moyen de chauffage et/ou un moyen de refroidissement configuré pour chauffer et/ou refroidir respectivement la paroi de moule.

Par ailleurs, l'invention concerne un procédé de fabrication d'un lingot en un matériau de lingot choisi parmi le silicium, le germanium et leurs mélanges, le procédé étant décrit dans la revendication 14 associée.

Préalablement à l'étape a), on peut paver la face de la paroi de fond de moule définissant le fond de la cavité au moyen d'au moins un germe formé du matériau de lingot. Le pavage peut être adapté à la production d'un lingot multicristallin, et par exemple être formé de germes présentant une largeur inférieure à 10 mm. En variante, il peut comporter des germes présentant une largeur comprise entre 10 et 400 mm adaptés à la production d'un lingot « mono-like ». Selon encore une autre variante, le pavage peut consister en unique germe pour former un lingot monocristallin.

De préférence, le matériau de lingot est le silicium.

De préférence, au cours d'une étape $a_0$) préalable à l'étape a), on dépose une charge de départ comportant le matériau de lingot dans la cavité et on fond la charge de départ pour former le bain. De préférence, au cours de l'étape $a_0$), on déplace l'écran de régulation thermique par rapport à l'ensemble de solidification de sorte à maintenir une interface, convexe ou concave, présentant une hauteur inférieure à 40 mm.

De préférence, à l'étape b), on déplace l'écran de régulation thermique par rapport à l'ensemble de solidification de sorte à maintenir une interface convexe entre le matériau de lingot solidifié et le matériau de lingot en fusion. De préférence, à l'étape b), on déplace l'écran de régulation thermique par rapport à l'ensemble de solidification de sorte que la hauteur de l'interface solide/liquide convexe soit constante sur plus de 80%, de préférence sur plus de 90%, de préférence sur plus de 95%, voire sur 100% de la hauteur du lingot à solidifier.

De préférence, à l'étape b), l'altitude de la portion d'isolation d'écran est inférieure à la hauteur du lingot au centre.

A l'étape b), de préférence, l'écran de régulation thermique est disposé selon au moins deux positions différentes selon lesquelles l'écran de régulation thermique est en regard du bain et/ou du lingot en formation.

De préférence, le lingot obtenu à la fin de l'étape b) est tel que le rapport de la hauteur du lingot sur la largeur du lingot est inférieur à 2,0, de préférence inférieur à 0,5. De préférence, le lingot obtenu à la fin de l'étape b) présente une hauteur comprise entre 100 mm et 700 mm et une largeur supérieure à 300 mm.

L'invention pourra être mieux comprise à la lecture de la description détaillée qui va suivre et du dessin annexé dans lequel :

- la figure 1 représente en coupe verticale un exemple de creuset selon l'invention,
- la figure 2 représente un détail de la paroi de manchon du creuset de la figure 1, et
- les figures 3 et 4 représentent un four selon l'invention.

Dans les différentes figures, des références identiques sont utilisées pour désigner des organes identiques ou analogues. Par ailleurs, dans les figures, les proportions des éléments constitutifs des creusets et fours n'ont pas été nécessairement respectées. Par ailleurs, par souci de clarté, certains éléments peuvent être représentés à distance les uns des autres alors qu'ils ne le sont pas en pratique.

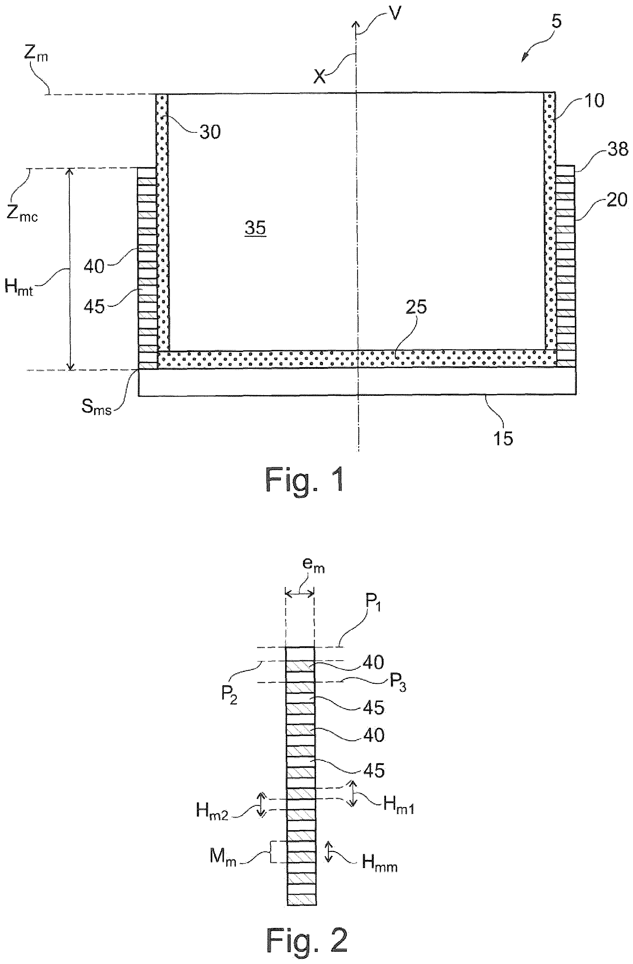

Le creuset 5 illustré sur la figure 1 comporte un moule 10, une sole 15 et un manchon de maintien 20. Le moule est formé de silice et comporte une paroi de fond de moule 25 s'étendant transversalement selon une direction axiale V, qui est verticale, et qui passe par les barycentres des sections transverses à la direction axiale du moule. Le moule comporte en outre une paroi latérale de moule 30 s'étendant selon la direction axiale à partir de la paroi de fond. La paroi latérale de moule et la paroi de fond de moule définissent une cavité 35 adaptée à contenir un bain de matériau de lingot en fusion, de préférence du silicium. Le moule repose sous l'effet de son poids propre sur la sole, qui est formée de graphite.

Le manchon de maintien comporte une paroi de manchon 38 qui ceinture toute la périphérie de la paroi latérale de moule, autour de la direction axiale. Il est par ailleurs au contact de la paroi latérale de moule.

Pour mettre en œuvre le procédé de solidification dirigée d'un lingot de silicium avec le moule de silice du creuset de la figure 1, le moule est chauffé à une température supérieure à la température de transition vitreuse de la silice qui le compose, ce qui induit une diminution temporaire de la rigidité du moule. Le matériau de manchon présente un module de Young tel que le manchon de maintien assure le maintien de la forme du moule au cours de la phase de transition vitreuse du moule. Ainsi, le manchon de maintien évite que le moule en silice ne se déforme trop sous l'effet de son ramollissement et de la pression induite par le matériau contenu dans la cavité. Le moule présente ainsi au cours de la solidification dirigée une forme sensiblement identique à celle qu'il présente à température ambiante.

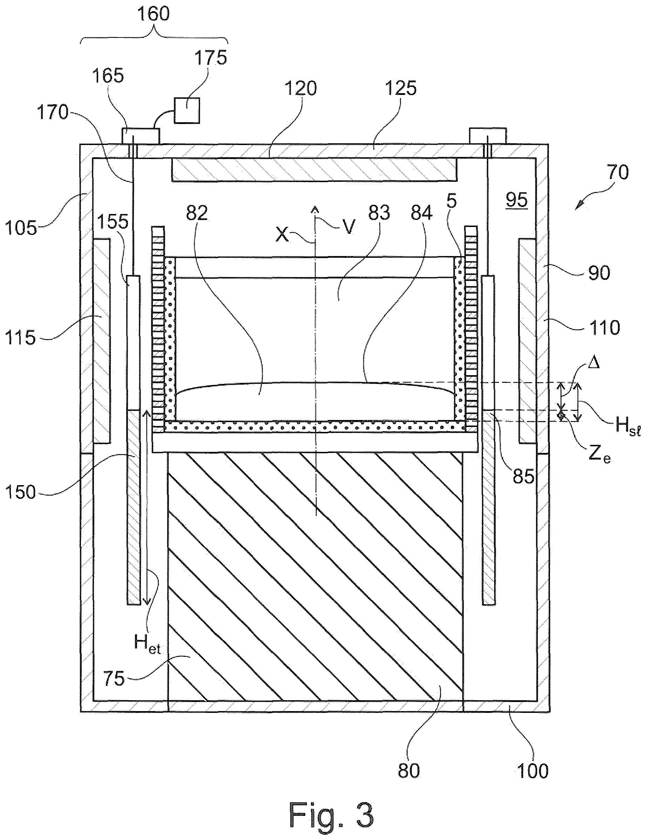

Comme observé plus en détail sur la figure 2, le manchon de maintien comporte une pluralité de régions d'isolation de manchon 40 formées de feutre de carbone et une pluralité de régions conductrices de manchon 45 formées de graphite. Les régions conductrices de manchon et les régions d'isolation de manchon présentent des formes de portions de tubes délimitées le long de la direction axiale par des plans radiaux $P_1$, $P_2$, $P_3$. Chaque portion de tube peut être monolithique ou composé d'un assemblage. Les régions conductrices de manchon et les régions d'isolation de manchon sont en outre alternées selon la direction axiale. Une région d'isolation de manchon est, par exemple, vissée de part et d'autre de la direction axiale à des régions conductrices de manchon adjacentes. Par ailleurs, les régions conductrices de manchon sont fixées, par exemple vissées, entre elles, de sorte que le manchon de maintien présente un module de Young adapté au maintien de la forme du moule lors de la solidification dirigée du lingot. Une région d'isolation de manchon et une région conductrice de manchon consécutives définissent un motif $M_m$ qui est répété périodiquement selon la direction axiale. Le motif présente une hauteur $H_{mm}$ comprise entre 10 mm et 200 mm. De préférence, la hauteur d'une région d'isolation de manchon $H_{m1}$ est comprise entre 5 mm et 100 mm et la hauteur d'une région conductrice de manchon $H_{m2}$ est comprise entre 5 mm et 195 mm. La hauteur $H_{mt}$ de la paroi de manchon est par exemple comprise entre 100 mm et 1000 mm . Dans l'exemple de la figure 1, l'altitude $z_m$ de l'extrémité supérieure de la paroi latérale de moule est supérieure à l'altitude $z_{mc}$ de la paroi de manchon. Dans une variante illustrée sur la figure 3, elle peut être inférieure ou égale à l'altitude de la paroi de manchon.

Comme cela a été précisé précédemment, dans l'exemple de la figure 1, les régions d'isolation de manchon et les régions conductrices de manchon sont disposées en alternance le long de la direction axiale. Lorsque le manchon de maintien est exposé à un flux de chaleur radial, les régions d'isolation de manchon définissent des barrières thermiques pour ledit flux. Ledit flux est alors conduit au travers de la paroi de manchon par l'intermédiaire de la région conductrice de manchon vers la paroi latérale de moule. Autrement dit, d'un point de vue thermique, les régions d'isolation de manchon et les régions conductrices de manchon sont disposées en parallèle au sein du matériau de manchon lorsqu'exposées à un flux de chaleur radial.

La paroi de manchon présente par ailleurs une épaisseur $e_m$, mesurée selon une direction radiale, comprise entre 5 mm et 50 mm.

Par ailleurs, le manchon de maintien repose sur la sole. Plus précisément, le contact entre le manchon de maintien et la sole s'effectue par l'intermédiaire de la région d'isolation de manchon disposée à l'extrémité inférieure du manchon de maintien, dite région de manchon d'extrémité. La surface de contact $S_{ms}$ entre le manchon de maintien et la sole est définie entièrement par la région de manchon d'extrémité. La région de manchon d'extrémité, formée d'un matériau présentant une conductivité thermique inférieure à la conductivité thermique de la région conductrice de manchon, définit une résistance thermique entre la région conductrice de manchon en graphite et la sole en graphite. De cette façon, la région d'extrémité de manchon permet d'éviter la propagation le long de la direction axiale d'un flux de chaleur dans la paroi de manchon ce qui facilite la régulation des flux thermiques radiaux imposés au lingot et matériaux de lingot en fusion lors de la solidification dirigée.

La figure 3 représente en coupe verticale un exemple de four 70 selon l'invention.

Le four comporte un ensemble de solidification 75 comportant le creuset 5 illustré sur la figure 1 et un bloc échangeur thermique 80. La cavité du moule 35 contient un lingot 82 en formation et un bain de matériau de lingot en fusion 83, séparés par une interface solide/liquide 84 convexe. Le creuset repose sur le bloc échangeur thermique. Le four comporte en outre un écran de régulation thermique 85 disposé radialement à l'extérieur du creuset, et qui dans la configuration du four illustrée sur la figure 3, entoure le creuset sur sa périphérie.

Le four comporte en outre une enceinte 90 en fibre de carbone définissant un logement d'enceinte 95 dans lequel l'ensemble de solidification et l'écran de régulation thermiques sont disposés. L'enceinte comporte une base 100 sur laquelle repose l'ensemble de solidification et un couvercle 105 amovible, par exemple mobile en translation par rapport à la base selon la direction axiale. Dans une configuration de fermeture du four, le couvercle repose sur la base de sorte à isoler le logement d'enceinte de l'extérieur. En particulier, l'enceinte définit une paroi latérale 110, sur laquelle est monté au moins un moyen de chauffage 115, par exemple à induction, pour chauffer le cas échéant, le lingot en formation 82 et le bain de matériau de lingot en fusion 83.

Le bloc échangeur thermique est par exemple une boîte à eau pour extraire la chaleur du creuset transmise par la paroi de fond de four.

Le four peut aussi comporter un moyen de chauffage supérieur 120, disposé sur une paroi de haut 125 de l'enceinte définie par le couvercle, pour chauffer axialement le bain de matériau de lingot en fusion. Les parois latérales de l'enceinte 90 peuvent être solidaires ou partiellement solidaires du couvercle 125. En particulier, la surface de jonction entre le couvercle et la base peut être disposée dans le même plan que la sole 15 au contact du moule. De cette façon, en déplaçant axialement le couvercle par rapport à la base, l'introduction et le déchargement du creuset dans le four sont facilités.

L'écran de régulation thermique est mobile relativement à l'ensemble de solidification selon la direction axiale. Il s'étend selon la direction axiale et est coaxial avec le creuset. Il se présente sous la forme d'un tube creux, et comporte une région d'isolation d'écran 150 formée de fibres de carbone à laquelle est superposée une région conductrice d'écran 155 en graphite. La région d'isolation d'écran présente une hauteur $H_i^{et}$ supérieure à plus de 50% de la hauteur du lingot à solidifier.

Le four comporte en outre un module de pilotage 160 pour déplacer l'écran de régulation thermique par rapport à l'ensemble de solidification.

Le module de pilotage 160 comporte un moteur 165 et un organe de liaison 170 relié au moteur et à l'écran de régulation thermique. Le moteur peut être actionné pour déplacer l'organe de liaison associé à l'écran de régulation thermique. Le module de pilotage comporte par ailleurs une unité de contrôle 175 reliée au moteur, par exemple électriquement. L'unité de contrôle est configurée pour lire un fichier comportant, en fonction d'un instant déterminé du procédé de solidification dirigée d'un lingot mis en œuvre au moyen du four, au moins un paramètre de pilotage étant par exemple la vitesse de déplacement et/ou la durée de déplacement et/ou la position relative suivant l'axe V de l'écran de régulation thermique. Elle est en outre configurée pour actionner le moteur de sorte à déplacer l'écran de régulation thermique en fonction de la valeur du paramètre de pilotage lu dans le fichier.

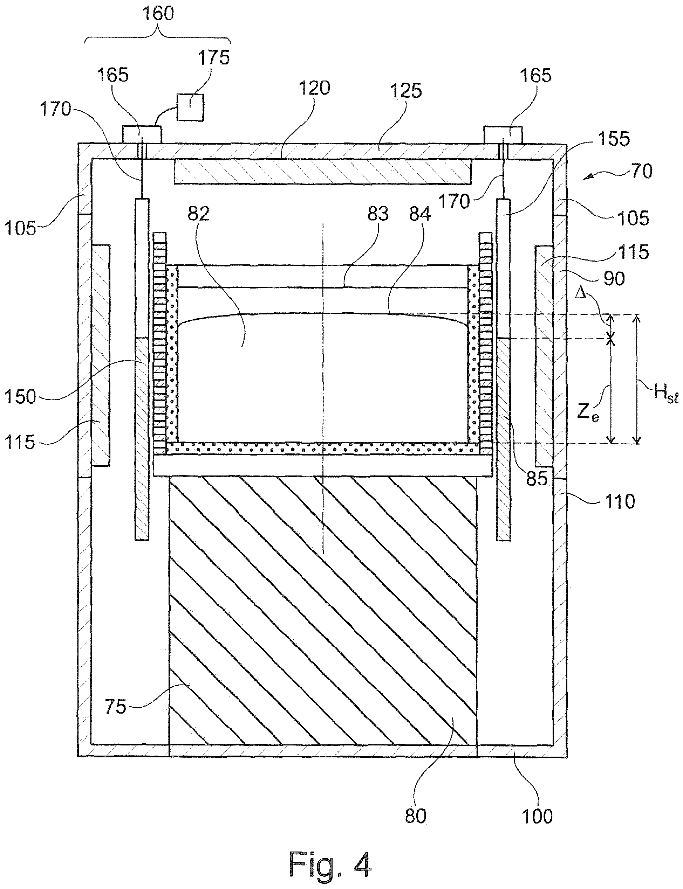

Les figures 3 et 4 illustrent par ailleurs la formation d'un lingot. La cavité du moule contient le lingot en formation 82 obtenu par solidification d'un bain 83 de matériau de lingot en fusion et séparé du bain par l'interface solide/liquide 84 convexe.

Sur la figure 4, par rapport à la figure 3, au cours de la solidification dirigée, l'interface solide/liquide a été déplacée selon la direction axiale. La masse de lingot solidifié a augmenté et le volume de bain liquide est réduit. L'écran de régulation thermique a été déplacé de manière à suivre l'interface solide/liquide pour maintenir sa convexité. Par exemple, comme illustré sur les figures 3 et 4, dans un mode de mise en œuvre du procédé, l'écran de régulation thermique peut être déplacé en cours de solidification dirigée du lingot de sorte que l'altitude $Z_e$ de la face supérieure de la région d'isolation d'écran séparant les régions d'isolation d'écran et conductrice d'écran reste inférieure à l'altitude maximale $H_{s1}$ de l'interface solide/liquide. Les altitudes sont mesurées par rapport à une référence commune, par exemple la face de la paroi de fond de moule en regard de la cavité. Ainsi, on isole radialement le lingot en formation en limitant l'échange de flux thermique radial avec les parois de l'enceinte du four. La température du lingot en formation est ainsi plus homogène, ce qui limite le développement de contraintes thermomécaniques au sein du lingot.

Le module de pilotage peut être configuré pour contrôler la différence Δ entre l'altitude maximale $H_{s1}$ de l'interface solide/liquide et l'altitude Ze de la face supérieure de la région d'isolation d'écran. Par exemple, l'altitude maximale $H_{s1}$ de l'interface liquide/solide peut être mesurée, par exemple par palpage automatisé. On peut ainsi définir une forme convexe spécifique de l'interface solide/liquide. Notamment, le module de pilotage peut être configuré pour que la différence Δ soit constante, notamment positive, de préférence inférieure à 50 mm, pendant plus de 90% de la durée de solidification du lingot. On limite ainsi le développement de grains parasites se développant à partir des parois du moule et les contraintes appliquées au solide.

Comme cela apparaît à présent, l'invention améliore la ségrégation des impuretés dans le lingot et réduit les contraintes appliquées au solide à l'origine du développement de défauts cristallins dans le lingot.

Bien entendu, l'invention n'est pas limitée aux exemples, fournis à titre illustratif, mais par l'ensemble des revendications associés.

**Revendications**

1. Creuset (5) pour la solidification dirigée d'un lingot en un matériau de lingot choisi parmi le silicium, le germanium et leurs mélanges, le creuset comportant :

   - un moule (10) comportant une paroi de fond de moule (25) et une paroi latérale de moule (30) s'étendant depuis la paroi de fond de moule le long d'une direction axiale (V), la paroi de fond de moule et la paroi latérale de moule définissant ensemble une cavité (35) pour contenir le matériau de lingot en fusion, et
   - un manchon de maintien (20) s'étendant selon la direction axiale et comportant un matériau de manchon dont la conductivité thermique est anisotrope et présente des composantes radiale $\lambda_r^{mc}$ et axiale $\lambda_x^{mc}$ telles que :

     $$\frac{\lambda_r^{mc}}{\lambda_x^{mc}} > 1{,}0$$

     ○ $\frac{\lambda_r^{mc}}{\lambda^{moule}} > 1{,}0$, $\lambda^{moule}$ étant la conductivité thermique du matériau de moule,

     ○ $\frac{\lambda_r^{mc}}{\lambda^{gr}} < 1{,}0$ et $\frac{\lambda_x^{mc}}{\lambda^{gr}} < 1{,}0$, $\lambda^{gr}$ étant la conductivité thermique du graphite, le manchon de maintien ceinturant la paroi latérale de moule autour de la direction axiale, les conductivités thermiques étant mesurées par application de la norme ASTM-1461 ou ASTM C-177.

2. Creuset selon la revendication 1, dans lequel le matériau de manchon présente un module de Young adapté au maintien de la forme du moule au cours de la solidification dirigée du lingot.

3. Creuset selon l'une quelconque des revendications 1 et 2, dans lequel la composante radiale $\lambda_r^{mc}$ de la conductivité thermique du matériau de manchon est supérieure à 10 W.m$^{-1}$.K$^{-1}$ et la composante axiale $\lambda_x^{mc}$ de la conductivité thermique du matériau de manchon est inférieure à 10 W.m$^{-1}$.K$^{-1}$, de préférence inférieure à 1 W.m$^{-1}$.K$^{-1}$.

**4.** Creuset selon l'une quelconque des revendications précédentes, dans lequel le manchon de maintien comporte une paroi de manchon (38), de préférence intégralement formée par le matériau de manchon, s'étendant selon la direction axiale et ceinturant la paroi latérale de moule autour de la direction axiale.

**5.** Creuset selon l'une quelconque des revendications précédentes, dans lequel le matériau de manchon est un matériau composite comportant pour plus de 95,0% de sa masse, une région conductrice de manchon (45) formée de graphite, et une région d'isolation de manchon (40) formée d'un matériau choisi parmi un feutre de carbone, une laine minérale, par exemple une laine d'alumine, et leurs mélanges.

**6.** Creuset selon l'une quelconque des revendications précédentes, la région conductrice de manchon et la région d'isolation de manchon s'étendant chacune de part en part de l'épaisseur (e$_m$) de la paroi de manchon.

**7.** Creuset selon l'une quelconque des revendications 5 et 6, dans lequel la région conductrice de manchon et la région d'isolation de manchon sont superposées l'une à l'autre selon la direction axiale et au contact l'une de l'autre et/ou la région conductrice de manchon et la région d'isolation de manchon présentent des sections identiques, selon un plan de coupe transversal à la direction axiale.

**8.** Creuset selon l'une quelconque des revendications 5 à 7, comportant une pluralité de régions conductrices de manchon et une pluralité de régions d'isolation de manchon, les régions conductrices de manchon et les régions d'isolation de manchon étant disposées en alternance selon la direction axiale, de préférence une des régions conductrices de manchon et une des régions d'isolation de manchon consécutivement disposées selon la direction axiale définissant ensemble un motif (M$_m$) qui est répété périodiquement le long de la direction axiale, le rapport de la hauteur (H$_{mm}$) d'un motif et l'épaisseur (e$_m$) de la paroi de manchon étant de préférence compris entre 0,1 et 5,0, de préférence compris entre 0,3 et 3,0.

**9.** Creuset selon l'une quelconque des revendications précédentes, comportant en outre une sole (15) disposée au contact de la paroi de fond de moule et du manchon de maintien, et étant formée d'un matériau de sole présentant une conductivité thermique $\lambda^{so}$

supérieure à la composante axiale $\lambda_x^{mc}$ de la conductivité thermique du matériau de manchon, de préférence le matériau de sole est le graphite, la surface de contact (S$_{ms}$) entre le manchon de maintien et la sole étant de préférence définie entièrement par la région d'isolation de manchon.

**10.** Creuset selon l'une quelconque des revendications précédentes, dans lequel le rapport de la hauteur de la cavité sur la largeur de la cavité est inférieur à 2,0, de préférence inférieur à 0,5.

**11.** Four (70) pour la solidification dirigée d'un lingot en un matériau de lingot choisi parmi le silicium, le germanium et leurs mélanges, le four comportant :

- un ensemble de solidification (75) comportant le creuset (5) selon l'une quelconque des revendications précédentes et un bloc échangeur thermique (80) au contact du creuset et superposé au creuset selon la direction axiale, et
- un écran de régulation thermique (85) s'étendant le long de la direction axiale et comportant un matériau d'écran dont la conductivité thermique est inférieure à la conductivité thermique du matériau de lingot, de préférence inférieure à 10 W.m$^{-1}$.K$^{-1}$. l'écran de régulation thermique et l'ensemble de solidification étant mobiles en translation l'un par rapport à l'autre selon la direction axiale, l'écran de régulation thermique entourant le creuset selon au moins une configuration du four.

**12.** Four selon la revendication 11, dans lequel l'écran de régulation thermique présente une région d'isolation d'écran (150) formée du matériau d'écran et une région conductrice d'écran (155) formée de graphite.

**13.** Four selon l'une quelconque des revendications 11 et 12, comportant un module de pilotage (160) configuré pour translater l'écran de régulation thermique par rapport à l'ensemble de solidification, notamment de sorte à maintenir une interface (84) convexe entre le lingot solidifié (82) et le bain (83) de matériau de lingot en fusion au cours de la solidification dirigée du lingot.

**14.** Procédé de fabrication d'un lingot (82) en un matériau de lingot choisi parmi le silicium, le germanium et leurs mélanges, de préférence étant le silicium, le procédé comportant au moins les étapes consistant à :

a) disposer d'un four selon l'une quelconque des revendications 11 à 13, la cavité du creuset contenant un bain (83) comportant le matériau de lingot en fusion, puis

b) procéder à la solidification du lingot (82) à partir du bain tout en déplaçant l'écran de régulation thermique relativement à l'ensemble de solidification selon la direction axiale.

15. Procédé selon la revendication précédente, comportant une étape $a_0$), préalable à l'étape a), au cours de laquelle on dépose une charge de départ comportant le matériau de lingot dans la cavité et on fond la charge de départ pour former le bain, et, de préférence, au cours de l'étape $a_0$), on déplace l'écran de régulation thermique par rapport à l'ensemble de solidification de sorte à maintenir une interface, convexe ou concave, présentant une hauteur inférieure à 40 mm.

**Patentansprüche**

1. Tiegel (5) zur gerichteten Erstarrung eines Ingots aus einem Ingotmaterial, das aus Silizium, Germanium und deren Mischungen ausgewählt ist, wobei der Tiegel aufweist:

   - eine Form (10), die eine Formbodenwand (25) und eine Formseitenwand (30), die sich von der Formbodenwand aus entlang einer axialen Richtung (V) erstreckt, aufweist, wobei die Formbodenwand und die Formseitenwand zusammen einen Hohlraum (35) zur Aufnahme des geschmolzenen Ingotmaterials definieren, und
   - eine Haltehülse (20), die sich in der axialen Richtung erstreckt und ein Hülsenmaterial aufweist, dessen Wärmeleitfähigkeit anisotrop ist und eine radiale $\lambda_r^{mc}$ und eine axiale Komponente $\lambda_x^{mc}$ aufweist, wobei gilt:

   $$\frac{\lambda_r^{mc}}{\lambda_x^{mc}} > 1,0,$$

   $$\frac{\lambda_r^{mc}}{\lambda^{Form}} > 1,0$$

   , wobei $\lambda^{Form}$ die Wärmeleitfähigkeit des Materials der Form ist,

   $$\frac{\lambda_r^{mc}}{\lambda^{gr}} < 1,0 \quad \text{und} \quad \frac{\lambda_x^{mc}}{\lambda^{gr}} < 1,0,$$

   wobei $\lambda^{gr}$ die Wärmeleitfähigkeit von Graphit ist,

   wobei die Haltehülse die Formseitenwand um die axiale Richtung herum umgibt, wobei die Wärmeleitfähigkeiten unter Anwendung der Norm ASTM-1461 oder ASTM C-177 gemessen werden.

2. Tiegel nach Anspruch 1, wobei das Hülsenmaterial einen Elastizitätsmodul aufweist, der die Beibehaltung der Gestalt der Form während der gerichteten Erstarrung des Ingots ermöglicht.

3. Tiegel nach einem der Ansprüche 1 und 2, wobei die radiale Komponente $\lambda_r^{mc}$ der Wärmeleitfähigkeit des Hülsenmaterials größer als 10 W.m$^{-1}$.K$^{-1}$ ist und die axiale Komponente $\lambda_x^{mc}$ der Wärmeleitfähigkeit des Hülsenmaterials kleiner als 10 W.m$^{-1}$.K$^{-1}$ ist, vorzugsweise kleiner als 1 W.m$^{-1}$.K$^{-1}$.

4. Tiegel nach einem der vorhergehenden Ansprüche, wobei die Haltehülse eine Hülsenwand (38) aufweist, die vorzugsweise einstückig aus dem Hülsenmaterial gebildet ist, sich in der axialen Richtung erstreckt und die Formseitenwand um die axiale Richtung herum umgibt.

5. Tiegel nach einem der vorhergehenden Ansprüche, wobei das Hülsenmaterial ein Verbundmaterial ist, das für mehr als 95,0 % seiner Masse einen leitfähigen Hülsenbereich (45), der aus Graphit gebildet ist, und einen isolierenden Hülsenbereich (40), der aus einem Material gebildet ist, das aus einem Kohlenstofffilz, einer Mineralwolle, zum Beispiel einer Aluminiumoxidwolle, und deren Mischungen ausgewählt ist, aufweist.

6. Tiegel nach einem der vorhergehenden Ansprüche, wobei sich der leitfähige Hülsenbereich und der isolierende Hülsenbereich jeweils beiderseits der Dicke ($e_m$) der Hülsenwand erstrecken.

7. Tiegel nach einem der Ansprüche 5 und 6, wobei der leitfähige Hülsenbereich und der isolierende Hülsenbereich in der axialen Richtung übereinander angeordnet sind und sich in Kontakt miteinander befinden und/oder der leitfähige Hülsenbereich und der isolierende Hülsenbereich in einer quer zur axialen Richtung verlaufenden Schnittebene identische Querschnitte aufweisen.

8. Tiegel nach einem der Ansprüche 5 bis 7, welcher mehrere leitfähige Hülsenbereiche und mehrere isolierende Hülsenbereiche aufweist, wobei die leitfähigen Hülsenbereiche und die isolierenden Hülsenbereiche in der axialen Richtung abwechselnd angeordnet sind, wobei vorzugsweise einer der leitfähigen Hülsenbereiche und einer der isolierenden Hülsenbereiche, die in der axialen Richtung aufeinander folgend angeordnet sind, zusammen ein Mus-

ter ($M_m$) definieren, welches in der axialen Richtung periodisch wiederholt wird, wobei das Verhältnis der Höhe ($H_{mm}$) eines Musters und der Dicke (em) der Hülsenwand vorzugsweise zwischen 0,1 und 5,0, vorzugsweise zwischen 0,3 und 3,0 liegt.

9. Tiegel nach einem der vorhergehenden Ansprüche, welcher außerdem eine Sohle (15) aufweist, die im Kontakt mit der Formbodenwand und der Haltehülse angeordnet ist und aus einem Sohlenmaterial gebildet ist, das eine Wärmeleitfähigkeit $\lambda^{so}$ aufweist, die größer als die axiale Komponente $\lambda_x^{mc}$ der Wärmeleitfähigkeit des Hülsenmaterials ist, wobei das Sohlenmaterial vorzugsweise Graphit ist, wobei die Kontaktfläche ($S_{ms}$) zwischen der Haltehülse und der Sohle vorzugsweise vollständig durch den isolierenden Hülsenbereich definiert ist.

10. Tiegel nach einem der vorhergehenden Ansprüche, wobei das Verhältnis der Höhe des Hohlraums zur Breite des Hohlraums kleiner als 2,0 ist, vorzugsweise kleiner als 0,5.

11. Ofen (70) zur gerichteten Erstarrung eines Ingots aus einem Ingotmaterial, das aus Silizium, Germanium und deren Mischungen ausgewählt ist, wobei der Ofen aufweist:

   - eine Erstarrungsanordnung (75), die den Tiegel (5) nach einem der vorhergehenden Ansprüche und einen Wärmetauscherblock (80), der sich mit dem Tiegel in Kontakt befindet und in der axialen Richtung über dem Tiegel angeordnet ist, aufweist, und
   - einen Temperaturregelungsschirm (85), der sich in der axialen Richtung erstreckt und ein Schirmmaterial aufweist, dessen Wärmeleitfähigkeit kleiner als die Wärmeleitfähigkeit des Ingotmaterials ist, vorzugsweise kleiner als 10 W.m$^{-1}$.K$^{-1}$,

   wobei der Temperaturregelungsschirm und die Erstarrungsanordnung relativ zueinander in der axialen Richtung translatorisch beweglich sind, wobei der Temperaturregelungsschirm gemäß wenigstens einer Konfiguration des Ofens den Tiegel umgibt.

12. Ofen nach Anspruch 11, wobei der Temperaturregelungsschirm einen isolierenden Schirmbereich (150), der aus dem Schirmmaterial gebildet ist, und einen leitfähigen Schirmbereich (155), der aus Graphit gebildet ist, aufweist.

13. Ofen nach einem der Ansprüche 11 und 12, welcher ein Steuermodul (160) aufweist, das dafür ausgelegt ist, den Temperaturregelungsschirm relativ zu der Erstarrungsanordnung translatorisch zu bewegen, insbesondere derart, dass eine konvexe Grenzfläche (84) zwischen dem erstarrten Ingot (82) und dem Bad (83) aus geschmolzenem Ingotmaterial während der gerichteten Erstarrung des Ingots erhalten bleibt.

14. Verfahren zur Herstellung eines Ingots (82) aus einem Ingotmaterial, das aus Silizium, Germanium und deren Mischungen ausgewählt ist und vorzugsweise Silizium ist, wobei das Verfahren wenigstens die folgenden Schritte umfasst:

   a) Bereitstellen eines Ofens nach einem der Ansprüche 11 bis 13, wobei der Hohlraum des Tiegels ein Bad (83) enthält, welches das geschmolzene Ingotmaterial umfasst, danach
   b) Erstarrenlassen des Ingots (82) ausgehend von dem Bad bei gleichzeitigem Verlagern des Temperaturregelungsschirms relativ zu der Erstarrungsanordnung in der axialen Richtung.

15. Verfahren nach dem vorhergehenden Anspruch, welches einen dem Schritt a) vorausgehenden Schritt $a_0$) umfasst, in welchem eine Ausgangscharge, die das Ingotmaterial umfasst, in den Hohlraum eingebracht wird und die Ausgangscharge geschmolzen wird, um das Bad zu bilden, und wobei vorzugsweise im Schritt $a_0$) der Temperaturregelungsschirm relativ zu der Erstarrungsanordnung so verlagert wird, dass eine konvexe oder konkave Grenzfläche erhalten bleibt, die eine Höhe von weniger als 40 mm aufweist.

**Claims**

1. Crucible (5) for the directed solidification of an ingot made of an ingot material chosen from among silicon, germanium and the mixtures thereof, the crucible comprising:

   - a mould (10) comprising a mould bottom wall (25) and a mould side wall (30) extending from the mould bottom wall along an axial direction (V), the mould bottom wall and the mould side wall together defining a cavity (35) for containing the molten ingot material, and
   - a holding sleeve (20) extending in the axial direction and comprising a sleeve material whose thermal conductivity is anisotropic and exhibits a radial component $\lambda_r^{mc}$ and an axial component $\lambda_x^{mc}$ such that:

   °

$$\frac{\lambda_r^{mc}}{\lambda_x^{mc}} > 1.0$$

∘ $\frac{\lambda_r^{mc}}{\lambda^{mould}} > 1.0$ , $\lambda^{mould}$ being the thermal conductivity of the mould material,

∘ $\frac{\lambda_r^{mc}}{\lambda^{gr}} < 1.0$ and $\frac{\lambda_x^{mc}}{\lambda^{gr}} < 1.0$ , $\lambda^{gr}$ being the thermal conductivity of graphite,

the holding sleeve encircling the mould side wall around the axial direction,

the thermal conductivities being measured by application of the ASTM-1461 or ASTM C-177 standard.

2. Crucible according to Claim 1, wherein the sleeve material exhibits a Young's modulus suitable for maintaining the form of the mould during the directed solidification of the ingot.

3. Crucible according to either one of Claims 1 and 2, wherein the radial component $\lambda_r^{mc}$ of the thermal conductivity of the sleeve material is greater than 10 W.m⁻¹.K⁻¹ and the axial component $\lambda_x^{mc}$ of the thermal conductivity of the sleeve material is less than 10 W.m⁻¹.K⁻¹, preferably less than 1 W.m⁻¹.K⁻¹.

4. Crucible according to any one of the preceding claims, wherein the holding sleeve comprises a sleeve wall (38), preferably integrally formed by the sleeve material, extending in the axial direction and encircling the mould side wall around the axial direction.

5. Crucible according to any one of the preceding claims, wherein the sleeve material is a composite material comprising, for more than 95.0% of its weight, a sleeve conductive region (45) formed by graphite, and a sleeve insulation region (40) formed by a material chosen from among a carbon felt, a mineral wool, for example an alumina wool, and the mixtures thereof.

6. Crucible according to any one of the preceding claims, the sleeve conductive region and the sleeve insulation region each extending right through the thickness ($e_m$) of the sleeve wall.

7. Crucible according to either one of Claims 5 and 6, wherein the sleeve conductive region and the sleeve insulation region are superposed on top of one another in the axial direction and in contact with one another and/or the sleeve conductive region and the sleeve insulation region have identical sections, in a cutting plane transversal to the axial direction.

8. Crucible according to any one of Claims 5 to 7, comprising a plurality of sleeve conductive regions and a plurality of sleeve insulation regions, the sleeve conductive regions and the sleeve insulation regions being arranged alternately in the axial direction, preferably one of the sleeve conductive regions and one of the sleeve insulation regions consecutively arranged in the axial direction together defining a pattern ($M_m$) which is repeated periodically along the axial direction, the ratio of the height ($H_{mm}$) of a pattern and the thickness ($e_m$) of the sleeve wall preferably lying between 0.1 and 5.0, preferably between 0.3 and 3.0.

9. Crucible according to any one of the preceding claims, further comprising a baseplate (15) arranged in contact with the mould bottom wall and the holding sleeve, and being formed by a baseplate material exhibiting a thermal conductivity $\lambda^{so}$ greater than the axial component $\lambda_x^{mc}$ of the thermal conductivity of the sleeve material, the baseplate material preferably being graphite, the contact surface ($S_{ms}$) between the holding sleeve and the baseplate preferably being defined entirely by the sleeve insulation region.

10. Crucible according to any one of the preceding claims, wherein the ratio of the height of the cavity to the width of the cavity is less than 2.0, preferably less than 0.5.

11. Kiln (70) for the directed solidification of an ingot made of an ingot material chosen from among silicon, germanium and the mixtures thereof, the kiln comprising:

   - a solidification assembly (75) comprising the crucible (5) according to any one of the preceding claims and a heat-exchanger block (80) in contact with the crucible and superposed on the crucible in the axial direction, and
   - a thermal regulation screen (85) extending along the axial direction and comprising a screen material whose thermal conductivity is less than the thermal conductivity of the ingot material, preferably less than 10 W.m⁻¹.K⁻¹,

   the thermal regulation screen and the solidification assembly being movable in translation with respect to one another in the axial direction, the thermal regulation screen surrounding the crucible in at least one configuration of the kiln.

12. Kiln according to Claim 11, wherein the thermal regulation screen has a screen insulation region (150) formed by the screen material and a screen conductive region (155) formed by graphite.

**13.** Kiln according to either one of Claims 11 and 12, comprising a control module (160) configured to translate the thermal regulation screen with respect to the solidification assembly, notably so as to maintain a convex interface (84) between the solidified ingot (82) and the bath (33) of molten ingot material during the directed solidification of the ingot.

**14.** Method for manufacturing an ingot (82) made of an ingot material chosen from among silicon, germanium and the mixtures thereof, preferably being silicon, the method comprising at least the steps consisting in:

a) having a kiln according to any one of Claims 11 to 13, the cavity of the crucible containing a bath (83) comprising the molten ingot material, then
b) proceeding with the solidification of the ingot (82) from the bath while moving the thermal regulation screen relative to the solidification assembly in the axial direction.

**15.** Method according to the preceding claim, comprising a step $a_0$), prior to step a), during which a starting charge comprising the ingot material is deposited in the cavity and the starting charge is melted to form the bath, and wherein, preferably, during step $a_0$), the thermal regulation screen is moved with respect to the solidification assembly so as to maintain a convex or concave interface having a height less than 40 mm.

Fig. 1

Fig. 2

Fig. 3

Fig. 4